(19) Europäisches Patentamt

European Patent Office

Office européen des brevets

(11) Veröffentlichungsnummer: **0 217 224**
A2

(12) **EUROPÄISCHE PATENTANMELDUNG**

(21) Anmeldenummer: 86112802.3

(22) Anmeldetag: 16.09.86

(51) Int. Cl.⁴: **H03M 1/68** , H03M 1/78 , //H03M1/06

(30) Priorität: 30.09.85 DE 3534862

(43) Veröffentlichungstag der Anmeldung:
08.04.87 Patentblatt 87/15

(84) Benannte Vertragsstaaten:
AT BE CH DE FR GB IT LI LU NL SE

(71) Anmelder: Siemens Aktiengesellschaft Berlin und München
Wittelsbacherplatz 2
D-8000 München 2(DE)

(72) Erfinder: Dielacher, Franz, Dipl.-Ing.
Auer von Weisbachstrasse 51
A-9500 Villach(AT)

(54) Segment-Digital-Analog-Umsetzer.

(57) Der Digital-Analog-Umsetzer verwendet ein Widerstandsnetzwerk, das ein R-2R-Netzwerk und eine Anzahl Segmente bildender parallel geschalteter Widerstände enthält, die gleich groß und gleich dem Eingangswiderstand des R-2R-Netzwerks sind. Neben einer besseren Kompensation des Relativfehlers und einer geringeren Strombelastung der Winderstände ergeben sich aus der Aufteilung des MSB-Sprungs in ene Anzahl kleinerer Sprünge geringere Anforderungen an die relative Genauigkeit der Widerstände, ohne daß das Netzwerk korrigiert werden muß.

EP 0 217 224 A2

## Segment-Digital-Analog-Umsetzer

Die Erfindung betrifft einen Digital-Analog-Umsetzer nach dem Oberbegriff des Patentanspruchs 1.

Auf dem Prinzip der Summation gewichteter Ströme beruhende Digital-Analog-Umsetzer, bei denen mit Hilfe einer Referenzspannungsquelle und schaltbarer gewichteter Widerstände gewichtete Ströme erzeugt und aufsummiert werden, stellen bereits bei wenigen Wichtungsstufen höchste Anforderungen an die Genauigkeit der Widerstände. Der auszuwertende Digitalcode, der die Schalter steuert und die gewichteten Widerstände auf den Summierungsknoten schaltet, erfordert beispielsweise bei einem Dualcode mit zehn Bits Widerstände mit einer relativen Genauigkeit besser ± 0,05 %.

Insbesondere bei der Herstellung von integrierten Digital-Analog-Umsetzern bereitet die Realisierung entsprechend genauer gewichteter Widerstände erhebliche Schwierigkeiten. Aus dem Buch von U. Tietze und Ch. Schenk: "Halbleiter-Schaltungstechnik", fünfte überarbeitete Auflage, Springer-Verlag, Berlin, Heidelberg, New York 1980, Seiten 635 ff. ist die Methode bekannt, die Gewichtung der Stufen durch Anwendung einer fortgesetzten Spannungsteilung mit Hilfe eines Leiternetzwerks vorzunehmen.

Die Genauigkeitsanforderungen an die Widerstände bleiben auch bei diesem sogenannten 2-RR-Netzewerk erhalten. So genügen hochgenaue Dünnfilmwiderstände mit einer relativen Genauigkeit von besser ± 0,2% für eine Auflösung einer Dualzahl mit neun Bits. Die Widerstandstoleranz ist dabei am kritischsten beim Hauptübertrag, d.h. beim Übertrag von der Dualzahl 011 111 111 zur Dualzahl 100 000 000. Bei längeren Dualzahlen sind deshalb noch genauere Widerstände oder eine Korrektur der Widerstände erforderlich.

Ein Digital-Analog-Umsetzer für 12 Bits ist beispielsweise nicht mehr monoton, wenn der Strom des most significant bit (MSB) seinen Sollwert um den Bruchteil 1/2048 unterschreitet. Daraus folgt eine relative Genauigkeit der Widerstände von ± 0,0244%. Ein digitaler oder analoger Abgleich der Widerstände mit Hilfe von Lasern bedeutet einen großen Zeitaufwand und ist abhängig von den verwendeten Widerständen nur bis zu einer bestimmten Anzahl Bits möglich. Eine Korrektur des Ausgangsstroms des Digital-Analog-Umsetzers mit Hilfe eines Korrekturnetzwerks bedeutet einen großen Aufwand.

Der Erfindung liegt die Aufgabe zugrunde, einen Digital-Analog-Umsetzer anzugeben, der bei einer Auflösung mehr als 9 Bit langer Dualzahlen, insbesondere bei Dualzahlen mit 12 Bit, ohne einen Widerstandsabgleich oder ein Korrekturnetzwerk für das R-2R-Netzwerk auskommen kann.

Diese Aufgabe wird bei einem Digital-Analog-Umsetzer der eingangs genannten Art erfindungsgemäß durch die Merkmale des kennzeichnenden Teils des Patentanspruchs 1 gelöst.

Der Erfindung liegt der Gedanke zugrunde, den Sprung des Hauptübertrags, d.h. den Sprung von einer Dualzahl, bei der bis auf das MSB alle Bits den logischen Wert 1 haben zu einer Dualzahl, bei der nur das MSB den logischen Wert 1 besitzt, in eine Anzahl kleinerer Sprünge aufzuteilen. Dazu wird ein R-2R-Netzwerk eingesetzt, das ohne Korrektur netzwerk oder ohne einen Abgleich der Widerstände auskommt. Dieses Netzwerk nimmt eine binäre Wichtung der jeweils niedrigstwertigen Bits vor. Der den jeweils höchstwertigen Bits entsprechende analoge Ausgangsstrom wird mit Hilfe eines Segment-Netzwerks erzeugt, das von den höchstwertigen Bits gesteuerte Segmente enthält, die dem R-2R-Netzwerk parallel geschaltet werden. Erfindungsgemäß wird dieses Segment-Netzwerk durch Widerstände und Schalter realisiert. Der Digital-Analog-Umsetzer bestitzt den Vorteil einer verbesserten Kompensation von Widerstandsungenauigkeiten, eines vereinfachten gewichteten Widerstands-und Schalternetzwerks, einer Verringerung der Strombelastung der Widerstände und einer Verringerung des Einflusses des Substratsteuerfaktors, wenn als Widerstände MOS-Transistoren verwendet werden, die entsprechend beschaltet sind.

Ausgestaltungen des Erfindungsgedankens sind in Unteransprüchen gekennzeichnet.

Die Erfindung wird im folgenden anhand eines in den Figuren der Zeichnung dargestellten Ausführungsbeispiels näher erläutert. Es zeigt:

Fig. 1 ein Teilersatzschaltbild eines Digital-Analog-Umsetzers mit R-2R-und Segment-Netzwerk und

Fig. 2 ein Diagramm zur Erläuterung eines erfindungsgemäßen Digital-Analog-Umsetzers für 12 Bits it sieben Segmenten.

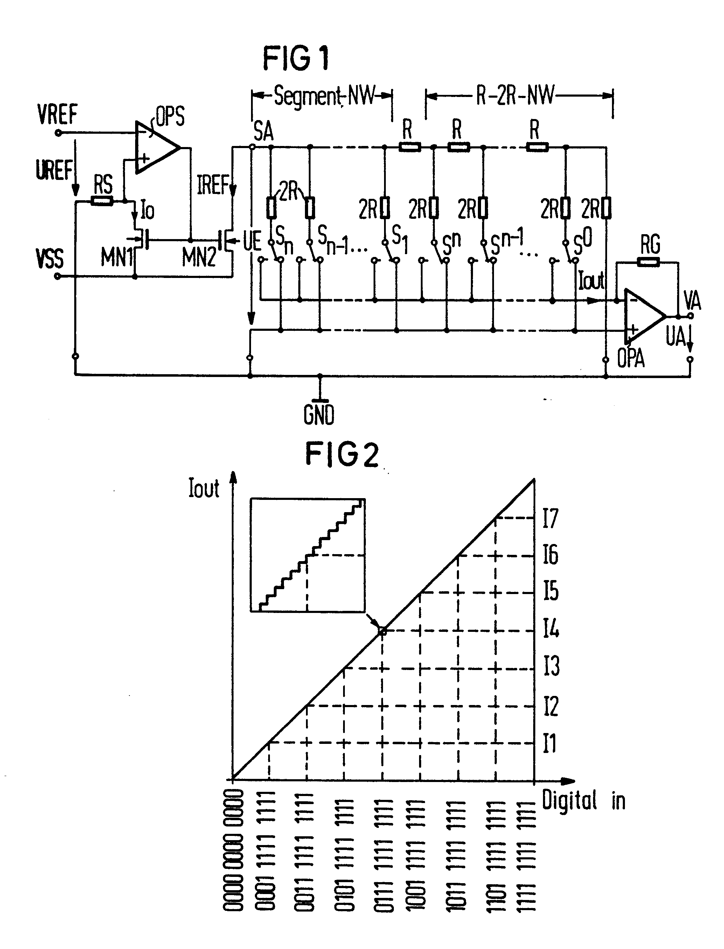

Gemäß Fig. 1 enthält der Digital-Analog-Umsetzer eine Referenz-Gleichspannungsquelle bzw. eine Referenz-Gleichstromquelle, die an den Eingang eines erfindungsgemäßen Widerstands-und Schalternetzwerks zur Umwandlung des digitalen Eingangscodes in einen analogen Ausgangsstrom angeschlossen wird und einen über einen Widerstand gegengekoppelten invertierenden Operationsverstärker zur Umwandlung des Ausgangsstroms des Widerstands-und Schalternetzwerks in eine Ausgangsspannung.

Die Referenz-Gleichstromquelle am Eingang des Digital-Analog-Umsetzers kann gemäß den korrespondierenden Patentanmeldungen VPA 85 E 5303 und VPA 85 E 5306 ausgebildet sein. Im Ausführungsbeispiel gemäß Fig. 1 enthält die Gleichstromquelle einen aus den n-Kanal-Metalloxid-Transistoren MN1 und MN2 gebildeten Stromspiegel. Der durch den Eingangstransistor MN1 fließende Strom Io ergibt sich aus einer an der Klemme VREF gegenüber einem Bezugspotential GND anliegenden Eingangs-Referenzspannung UREF mit Hilfe eines den Eingangsstrom Io bestimmenden Widerstandes RS. Dabei wird der Eingangsstrom Io mit Hilfe eines Operationsverstärkers OPS konstant gehalten.

Am invertierenden Eingang des Operationsverstärkers OPS liegt die Eingangsklemme VREF und am nichtinvertierenden Eingang des Operationsverstärkers liegt das Potential des Verbindungspunktes des Ausgangskreises des Transistors MN1 mit dem Widerstand RS. Der andere Anschluß des Widerstandes RS ist mit dem Bezugspotential GND verbunden. Das Gate des Eingangstransistors MN1 und das Gate des Ausgangstransistors MN2 des Stromspiegels sind miteinander und mit dem Ausgang des Operationsverstärkers OPS verbunden. Die als Source dienenden Anschlüsse der Ausgangskreise der Transistoren MN1 und MN2 liegen gemeinsam an einer Klemme VSS. Den Ausgang der Stromquelle bildet die Klemme SA, die an den als Drain dienenden Anschluß des Ausgangstransistors MN2 des Stromspiegels angeschlossen ist. Im Ausgangskreis dieses Transistors fließt der sich gemäß dem Übersetzungsverhältnis der beiden Transistoren des Stromspiegels ergebende Referenzstrom IREF in Abhängigkeit vom Eingangsstrom Io des Stromspiegels. Die Klemme SA besitzt gegenüber dem Bezugspotential GND die Eingangsspannung UE.

Das erfindungsgemäße Widerstandsnetzwerk enthält, von der Eingangsklemme SA als Eingangsknoten ausgehend, parallel liegende Widerstände 2R, denen über einen Widerstand R ein an sich bekanntes R-2R-Netzwerk parallel geschaltet ist. Mit Ausnahme des Lastwiderstandes 2R des R-2R-Netzwerks sind die ausgangsseitigen Anschlüsse der Widerstände 2R dieses Netzwerks sowie die ausgangsseitigen Anschlüsse der dazu parallel liegenden Widerstände jeweils mit den Anschlüssen zugeordneter Schalter verbunden, die in beiden Schaltstellungen Strom führen. Je ein weiterer Anschluß der Schalter und der ausgangsseitige Anschluß des Lastwiderstandes 2R sind an das Bezugspotential GND angeschlossen.

Der jeweils dritte Anschluß der Wechselschalter ist an den invertierenden Eingang eines über einen Widerstand RG gegengekoppelten Operationsverstärkers OPA gelegt, dessen Ausgang mit der Klemme VA verbunden ist, die die Ausgangsklemme des Digital-Analog-Umsetzers darstellt und gegenüber der Bezugsspannung GND die Spannung UA aufweist. Die dem R-2R-Netzwerk zugeordneten Schalter sind mit dem Bezugszeichen $S^0$ bis $S^{n-1}$ und $S^n$ versehen gemäß der durch sie vorgenommenen binären Wichtung des die Schalter steuernden binären digitalen Teilcodes. Die Schalter der Segmente des diesem Netzwerk parallel geschalteten Segment-Netzwerks sind durch die Bezugszeichen $S_1$ bis $S_{n-1}$ und $S_n$ gekennzeichnet.

Der Wert der einzelnen parallel geschalteten Widerstände des Segment-Netzwerks ist jeweils gleich groß und gleich groß wie der Eingangswiderstand des R-2R-Netzwerks. Entweder besitzen die Segmentwiderstände den Wert R oder, wie in Fig. 1, den Wert 2R, wobei im letzten Fall das R-2R-Netzwerk über einen weiteren Widerstand R in Serie zum R-2R-Netzwerk mit dem Segment-Netzwerk verbunden ist. Dadurch wird der Referenzstrom IREF, der in den Eingang SA des erfindungsgemäßen Netzwerks fließt, in eine Anzahl gleich großer Teilströme aufgeteilt, wobei der in das R-2R-Netzwerk fließende Teilstrom dort binär gewichtet aufgeteilt wird. Für die Ansteuerung der Schalter $S_1$ bis $S_n$ der Segmente des Segment-Netzwerks werden die höchstwertigen Bits (MSBs) des digitalen Eingangscodes verwendet. Dabei müssen die für die Absteuerung der Schalter $S_1$ bis $S_n$ der Segmente verwendeten Bits dekodiert werden, da die einzelnen Segmentströme gleich groß und nicht, wie im R-2R-Netzwerk, binär gewichtet sind. Aus der Anzahl der Segmente ergibt sich die für die Ansteuerung der Schalter der Segmente erforderliche Anzahl von Bits.

Die Funktion einer erfindungsgemäßen Schaltung gemäß Fig. 1 läßt sich anhand des Diagramms nach Fig. 2 erläutern. Das Diagramm gibt die Ein/Ausgangs-Kennlinie für einen 12 Bit-Digital-Analog-Umsetzer an. Die insgesamt 4096 möglichen Stufen des Digital-Analog-Umsetzers werden mit einer Segmentierung von 8 x 512 Stufen realisiert. Für die 512 digitalen Stufen ist ein 9 Bit-R-2R-Netzwerk vorgesehen, das eine binäre Wichtung vornimmt. Für die 8 Stufen ist ein Segment-Netzwerk mit 7 Segmenten erforderlich.

Im Diagramm gemäß Fig. 2 ist auf der Abzisse das die Schalter des erfindungsgemäßen Netzwerks steuernde digitale Eingangswort "digital in" im Binärcode in Abständen von jeweils 512 Bit aufgetragen. Die Ordinate ist mit dem analogen Ausgangsstrom Iout bezeichnet, der in den invertierenden Eingang des Operationsverstärkers OPA fließt.

Die gemäß Fig. 2 lineare Kennlinie des analogen Ausgangsstroms in Abhängigkeit vom digitalen Eingangscode ist in Ordinatenrichtung in acht lineare Unterabschnitte mit den jeweiligen aufsummierten Segmentströmen I1 bis I7 aufgeteilt die sich ergeben, wenn keiner bis alle der Schalter S$_1$ bis S$_n$ auf den invertierenden Eingang des Operationsverstärkers OPA geschaltet sind. Je nach Ansteuerung der Schalter bzw. für jeden der aufsummierten Segmentströme I1 bis I7 werden jeweils die 512 Stufen des des 9 Bit-Digital-Analog-Umsetzers durchlaufen. Für einen engen Bereich vom Segmentstrom I3 bis in den Segmentstrom I4 sind in Fig. 2 eine Anzahl der Stufen des R-2R-Netzwerks vergrößert herausgezeichnet.

Die sieben Widerstände der Segmente mit jeweils dem Wert 2R müssen auf 12 Bit genau sein. Dagegen braucht das R-2R-Netzwerk nur auf 9 Bit entsprechend 512 Stufen genau zu sein, d.h., daß die Widerstände dieses Netzwerks eine relative Genauigkeit von ± 0,2% besitzen können, ohne daß das R-2R-Netzwerk korrigiert werden muß. Der Hauptübertrag des Digital-Analog-Umsetzers, d.h. der Übertrag von der Dualzahl 011 111 111 zur Dualzahl 100 000 000, wird bei jedem der Segmente wiederholt und ist deshalb um den Faktor 4 unkritischer als der Hauptübertrag bei einem reinen R-2R-Netzwerk für 12 Bit.

Als weiterer Vorteil ergibt sich, daß die Übertragungskennlinie des erfindungsgemäßen Digital-Analog-Umsetzers bei gleicher Widerstandstoleranz einen kleineren Lineari tätsfehler aufweist als die Übertragungskennlinie eines reinen R-2R-Netzwerks für 12 Bit. Auch die differentielle Nichtlinearität, d.h. die Abweichung des Abstandes zweier benachbarter Analogwerte vom idealen 1-LSB-Abstand, ist bei einem erfindungsgemäßen Digital-Analog-Umsetzer verbessert, so daß bei größerer Widerstolerantz Monotonie erreicht wird als bei einem konventionellen 12 Bit-R-2R-Netzwerk. In vielen Anwendungen ist die einheitliche Schrittgröße wichtiger als die möglichst gute Anpassung der Umsetzerkennlinie an eine ideale Gerade, da es wenig Transducer mit einer Linearität besser 0,1% gibt.

Abhängig von der Genauigkeit der Widerstände des Widerstandsnetzwerks eines Digital-Analog-Umsetzers muß jeweils eine Anzahl den MSBs zugeordneter Widerstände korrigiert werden. Bei einer geforderten relativen Widerstandsgenauigkeit von ± 0,2%, die Dünnfilmwiderstände übertreffen, müßten bei einem erfindungsgemäßen 12 Bit-Digital-Analog-Umsetzer gemäß Fig. 1 nur die Widerstände des Segment-Netzwerks korrigiert bzw. abgeglichen werden. Diese Maßnahme ist erheblich einfacher und erfordert einen geringeren Zeitaufwand als eine Korrektur oder ein Abgleich der Widerstände des R-2R-Netzwerks. Bei einer größeren Widerstandsungenauigkeit müssen deshalb auch die MSBs des R-2R-Netzwerks korrigiert bzw. abgeglichen werden, wodurch der Korrekturaufwand erheblich ansteigt.

Bei einer Segmentierung von 16 $^\times$ 256 für einen 12-Bit-Digital-Analog-Umsetzer müssen die Widerstände des R-2R-Netzwerks auf ± 0,4% genau sein. In diesem Fall er höht sich jedoch die Anzahl der zu korrigierenden bzw. abzugleichenden Segment-Widerstände auf 15.

Neben Dünnfilmwiderständen kommen auch Polysilicium-Widerstände in Frage, die mit einer erreichbaren relativen Genauigkeit von besser 1% hergestellt werden können. Ohne Korrektur-bzw. Abgleichmaßnahmen lassen sich damit 7 Bit auflösen. Für einen 12 Bit-Umsetzer müssen deshalb die fünf MSBs korrigiert bzw. abgeglichen werden. Abgleichmaßnahmen erfolgen vorteilhaft durch Lasertrimm, wobei ein digitaler Ableich aufgrund des Durchtrennens von Leiterbahnen ungenauer ist als ein analoger Abgleich, dafür aber einen geringeren Zeitaufwand erfordert.

Als Widerstände für das Widerstandsnetzwerk eignen sich vorteilhaft auch als Widerstände beschaltete MOS-Transistoren. Mit den erfindungsgemäßen Digital-Analog-Umsetzer läßt sich dabei der Einfluß des Substratsteuerfaktors verringern, der über die Schwellenspannung den R$_{on}$-Wert beeinflußt. Durch die Segmentierung verringern sich die an den Längswiderständen R des R-2R-Netzwerks ergebenden unterschiedlichen Substratspannungen, die sich direkt auf die Schwellenspannungen und den R$_{on}$-Wert auswirken.

Eine andere Möglichkeit zum Erreichen des geforderten Auflösungsvermögens besteht in der Korrektur des Ausgangsstromes Iout mit Hilfe eines Korrekturnetzwerks. Dabei wird die Abweichung des Ausgangsstromes vom Sollwert festgestellt und gespeichert. Der Fehler des Ausgangsstroms wird bei der Digital-Analog-Umsetzung durch das Korrekturnetzwerk, z.B. ein Fehlerkorrektur-Digital-Analog-Umsetzer, korrigiert.

Für ddie Speicherung des Fehlers des Ausgangsstroms selbst ergeben sich zwei Möglichkeiten. Einmal kann man den Fehler des Netzwerks durch eine zusätzliche Schaltung direkt auf dem Chip messen und in einen Speicher mit wahlweisem Zugriff (RAM) speichern. Dabei kann der Fehler des Netzwerks jederzeit erfaßt und das RAM neu programmiert werden. Diese Form der Korrektur erfaßt damit auch Alterungsvorgänge und teilweise den Temperaturgang des die Digital-Analog-Umwandlung vornehmenden Netzwerks.

Das Korrekturnetzwerk kann aber auch durch einen programmierbaren Festwertspeicher (PROM) gesteuert werden, bei dem der Fehler des Netzwerks unter festzulegenden Bedingungen, z.B. der Temperatur, nur einmal bestimmt und dementsprechend das PROM programmiert wird. Gegenüber der direkten Korrektur der Widerstände, z.B. durch Laserabgleich, besitzt auch diese Korrekturform den Vorteil, daß das PROM erst nach erfolgter Montage des Chips programmiert werden muß. Fehler, die durch das Zersägen der Scheibe oder die Montage des Chips entstehen, werden durch die Korrektur berücksichtigt.

Der Temperaturgang eines erfindungsgemäßen Digital-Analog-Umsetzers gemäß Fig. 1 läßt sich in erster Näherung vollständig kompensieren, wenn die Referenzspannung UREF an der Klemme VREF des Umsetzers mit Hilfe eines Widerstandes RS in einen das Netzwerk speisenden Referenzstrom IREF umgeformt wird und der Widerstand RS dieser Stromquelle den gleichen Temperaturgang besitzt wie der Widerstand RG im Gegenkopplungszweig des invertierenden Ausgangs-Operationsverstärkers OPA. Eine derartige Kompensation der Temperaturgänge von Digital-Analog-Umsetzern ist in der korrespondierenden Patentanmeldung VPA 85 E 5306 angegeben. Darin ist auch vorgesehen, daß der Referenzstrom IREF verschiedene Polaritäten haben kann und damit die Ausgangsspanng UA des Digital-Analog-Umsetzers je nach gewünschtem Anwendungzweck bipolar sein kann.

## Ansprüche

1. Integrierbarer Digital-Analog-Umsetzer, bei dem der eine Anschluß einer Referenz-Gleichspannungsquelle (VREF) bzw. einer Referenz-Gleichstromquelle (SA) an den Eingang eines ein R-2R-Netzwerk enthaltenden Netzwerks und der andere Anschluß an Masse (GND) und an jeweils den ersten Anschluß einer Anzahl Wechselschalter ($S^o$ bis $S^n$, $S_1$ bis $S_n$) gelegt ist, die durch jeweils gemeinsam gesteuerte Transistoren realisiert sind, bei denen der in beiden Schaltstellungen als stromführender Anschluß beibehaltene zweite Anschluß der Wechselschalter ($S^o$ bis $S^n$, $S_1$ bis $S_n$) mit je einem Ausgang des Netzwerks verbunden und der jeweils dritte Anschluß der Wechselschalter ($S^o$ bis $S^n$, $S_1$ bis $S_n$) an den invertierenden Eingang (-) eines über einen Widerstand (RG) gegengekoppelten, den Ausgang des Umsetzers bildenden Operationsverstärkers (OPA) gelegt ist, **dad urch gekenn-zeichnet,** daß das Netzwerk aus einem Widerstands-netzwerk (Segment NW, R-2R-NW) gebildet wird, in dem eine Anzahl Widerstände (2R) parallel zum R-2R-Netzwerk (R-2R-NW) geschaltet sind.

2. Anordnung nach Anspruch 1, **dadurch gekennzeichnet,** daß die parallel geschalteten Widerstände (2R) gleich groß sind.

3. Anordnung nach Anspruch 1 und 2, **dadurch gekennzeichnet,** daß die parallel geschalteten Widerstände wertmäßig gleich groß wie der Eingangswiderstand des R-2R-Netzwerks (R-2R-NW) sind.

4. Anordnung nach Anspruch 1 und 2, **dadurch gekennzeichnet,** daß die parallel geschalteten Widerstände (2R) wertmäßig doppelt so groß wie der Eingangs-widerstand des R-2R-Netzwerks (R-2R-NW) sind und das Segment-Netzwerk (Segment-NW) und das R-2R-Netzwerk (R-2R-NW) über einen Widerstand (R) miteinander verbunden sind.

5. Anordnung nach Anspruch 1 bis 4, **dadurch gekennzeichnet,** daß die Ansteuerung der den parallelgeschalteten Widerständen (2R) zugeordneten Wechselschalter ($S_1$ bis $S_n$) mit Hilfe der höchstwertigen Bits des auszuwertenden Digitalcodes erfolgt.

6. Anordnung nach Anspruch 1 bis 5, **dadurch gekennzeichnet,** daß die zur Ansteuerung der den parallelgeschalteten Widerständen (2R) zugeordneten Wechselschalter ($S_1$ bis $S_n$) verwendeten Bits dekodiert werden.

7. Anordnung nach Anspruch 1 bis 6, **dadurch gekennzeichnet,** daß die zur Ansteuerung der dem R-2R-Netzwerk zugeordneten Wechselschalter ($S^o$ bis $S^n$) verwendeten Bits in an sich bekannter Weise eine binäre Wichtung realisieren.

8. Anordnung nach Anspruch 1 bis 7, **dadurch gekennzeichnet,** daß der Ausgangsstrom (Iout) des Netzwerks (Segment-NW-R-2R-NW) mit Hilfe eines Korrekturnetzwerks korrigiert wird.

9. Anordnung nach Anspruch 1 bis 7, **dadurch gekennzeichnet,** daß das Korrekturnetzwerk mit Hilfe eines PROM und eines Korrektur-Digital-Analog-Umsetzers realisiert wird.

10. Anordnung nach Anspruch 1 bis 7, **dadurch gekennzeichnet,** daß das Korrekturnetzwerk mit Hilfe eines RAM und eines Korrektur-Digital-Analog-Umsetzers realisiert wird.

11. Anordnung nach Anspruch 1 bis 10, **dadurch gekennzeichnet,** daß die Widerstände -(R, 2R) des Netzwerks (Segment-NW, R-2R-NW) als Dünnfilmwiderstände ausgebildet sind.

12. Anordnung nach Anspruch 1 bis 11, **dadurch gekennzeichnet,** daß die Widerstände -(R-2R) des Netzwerks (Segment-NW, R-2R-NW) als Polysiliciumwiderstände ausgebildet sind.

13. Anordnung nach Anspruch 1 bis 10, **dadurch gekennzeichnet,** daß die Widerstände des Widerstandsnetzwerks (Segment-NW, R-2R-NW) durch als Widerstände ausgebildete und geschaltete Metalloxid-Halbleitertransistoren ausgebildet sind.

14. Anordnung nach Anspruch 1 bis 13, **dadurch gekennzeichnet,** daß die Referenzspannung (UREF) der Referenzgleichspannungsquelle mit Hilfe eines Widerstandes (RS) mit gleichem Temperaturgang wie der Widerstand (RG) im Gegenkopplungskreis des Ausgangs-Operationsverstärkers (OPA) in einen das Netzwerk - (Segment-NW, R-2R-NW) speisenden Referenzstrom (IREF) umgeformt wird.

15. Anordnung nach Anspruch 1 bis 14, **gekennzeichnet** durch die Ausbildung der Referenz-Gleichstromquelle gemäß dem Gegenstand der Patentanmeldung VPA 85 E 5306.

16. Anordnung nach Anspruch 1 bis 15, **gekennzeichnet** durch die Ausbildung der Referenz-Gleichstromquelle gemäß dem Gegenstand der Patentanmeldung VPA 85 E 5303.

# FIG 1

# FIG 2